# EUROPEAN PATENT APPLICATION

(11) **EP 4 513 751 A1**
(43) Date of publication of application: **26.02.2025**
(21) Application number: 23791335.5
(22) Date of filing: 20.04.2023
(51) Int. Cl.: H03F 1/26, H03F 1/56, H03F 3/193, H03G 3/30

(54) **LOW NOISE AMPLIFIER AND CORRESPONDING RADIO FREQUENCY FRONT-END MODULE, METHOD, AND MOBILE TERMINAL**

(30) Priority: 20.04.2022 CN 202210420668; 15.12.2022 CN 202211611077; 15.12.2022 CN 202211616062
(71) Applicant: Vanchip (Tianjin) Technology Co. Ltd, Tianjin 300457 (CN)
(72) Inventor: WANG, Jiefu, Tianjin 300457 (CN); ZHANG, Jun, Tianjin 300457 (CN)
(74) Representative: Wang, Bo
(86) International application number: PCT/CN2023/089624
(87) International publication number: WO 2023/202683

(57) **Abstract**

Disclosed in the present invention are a low noise amplifier and a corresponding radio frequency front-end module, a method, and a mobile terminal. According to the low noise amplifier, high isolation among input ports is achieved by means of a plurality of groups of input amplifiers and a plurality of groups of input switch tubes, and the area occupied by a circuit is also saved. By decomposing each input amplifier into a plurality of groups of amplifying units and by means of inter-stage switches connected to the plurality of groups of amplifying units, and by controlling the turning on of different combinations of inter-stage switches, multiple different gains of the amplifier are achieved. By sharing at least one output amplifier, the high gain and high isolation of the amplifier are guaranteed, and the circuit area can be minimized. The low noise amplifier can be used in the mobile terminal to serve as an important component of a communication assembly such as the radio frequency front-end module.

## Description

### BACKGROUND

### Technical Field

The present invention relates to the field of radio frequency integrated circuit technologies, and relates to a low noise amplifier, and to a radio frequency front-end module including the low noise amplifier, a radio frequency signal transmission control method, and a mobile terminal.

### Related Art

In a mobile communication system, a mobile terminal with a communication function needs to have a dual function of transmitting and receiving signals, and needs to operate in different communication frequency bands and different communication modes. As communication technologies evolve and the range of communication frequency bands expands, there is an increasing need for mobile terminals to support more frequency bands. For receive paths of radio frequency signals, one or more particular frequency signals are often selected from signals of a radio frequency front-end module, and are amplified and then transferred to a receiver, to achieve a high signal-to-noise ratio, thereby ensuring communication quality. A low noise amplifier (LNA for short) in the radio frequency front-end module plays a key role. Due to system requirements of the receiver, for received signals of different strengths, the low noise amplifier needs to provide different gains for signals to be amplified. In addition, more communications standards such as Bluetooth, Wi-Fi, and NFC technologies exist in a same mobile terminal (for example, a mobile phone). This poses new challenges for areas, power consumption requirements, and the like of amplification units.

### SUMMARY

A primary technical problem to be resolved by the present invention is to provide a low noise amplifier. The low noise amplifier can implement multipath input and output in various gain modes, and meet the requirement of low power consumption.

Another technical problem to be resolved by the present invention is to provide a radio frequency front-end module including the foregoing low noise amplifier.

Still another technical problem to be resolved by the present invention is to provide a radio frequency signal transmission control method for the foregoing radio frequency front-end module.

Yet another technical problem to be resolved by the present invention is to provide a mobile terminal including the foregoing radio frequency front-end module.

To achieve the above objectives, the following technical solutions are used in the present invention.

According to a first aspect of embodiments of the present invention, a low noise amplifier is provided, including: a plurality of input amplifiers and a plurality of signal input ends, where a quantity of the input amplifiers is greater than or equal to a quantity of the signal input ends;
a plurality of input coupling switches, where two ends of each input coupling switch are respectively connected to one signal input end and an input end of one input amplifier; and
each input amplifier includes at least one amplification unit, and control ends of the amplification units are connected together to form an input end of the input amplifier; and
a plurality of inter-stage switches, where one end of each inter-stage switch is connected to an output end of a corresponding amplification unit in each input amplifier, the other ends of the inter-stage switches are connected together to form a common end, and
the common end is connected to one output amplifier.

Preferably, the output amplifier includes:
a configurable load circuit, where an output end of the load circuit is connected to an output end of the low noise amplifier via an output matching circuit, and the other end of the load circuit is connected to a power source; and
a driving circuit, where one end of the driving circuit is connected to the common end of the inter-stage switches, and the other end of the driving circuit is connected to the output end of the load circuit.

Preferably, the load circuit includes a variable inductor, a variable resistor, and a variable capacitor connected in parallel. A resonant frequency of the load circuit is adjusted and different output impedance is provided by changing capacitance of the variable capacitor and resistance of the variable resistor.

Preferably, the driving circuit includes at least one transistor. The transistor has a drain connected to the output end of the load circuit, a source connected to the common end of the plurality of inter-stage switches, and a gate connected to a control voltage.

Preferably, each input amplifier includes at least two amplification units. An output end of each amplification unit is connected to a corresponding inter-stage switch. An amplification gain varies at least partially depending on a combination of inter-stage switches that are either turned on or off.

Preferably, the input amplifiers each include a same quantity of amplification units. Control ends of the amplification units in a same input amplifier are connected together and share one single bias voltage. Different amplifiers are connected to different independent bias voltages. Output ends of corresponding amplification units in each amplifier are connected together, and are connected to an input end of a same inter-stage switch.

Preferably, each amplification unit includes at least one transistor. A radio frequency signal is transmitted to a gate of the transistor. When both the transistor and the inter-stage switch connected to the transistor are turned on, the radio frequency signal is amplified by the transistor and is coupled to a corresponding inter-stage switch by a drain of the transistor. A source of the transistor is coupled to ground via a degeneration inductor.

Preferably, each input coupling switch includes at least one serial capacitor and a parallel shunt switch on a signal path. When the input coupling switch is turned on, the parallel shunt switch is turned off, and a radio frequency signal is transmitted to the input end of the input amplifier and amplified. When the input coupling switch is turned off, the parallel shunt switch is turned on and grounded, and the signal path does not amplify an inputted signal.

Preferably, the input coupling switch further includes a serial switch or a parallel switch resistance branch, or a combination thereof on the signal path.

When the input coupling switch is turned on, a radio frequency signal is transmitted to the input end of the input amplifier and amplified, and a switch in the parallel switch resistance branch is on in at least one gain mode. When the input coupling switch is turned off, the serial switch is turned off, the parallel shunt switch is turned on and grounded, and the signal path does not amplify a signal.

Preferably, the low noise amplifier further includes at least one bypass circuit.

One end of the bypass circuit is connected to an output end of the low noise amplifier, and the other end of the bypass circuit is connected to an input end of one input amplifier. At least one serial control switch is connected between an output end of a load circuit and the output end of the low noise amplifier. When the bypass circuit is enabled, the input amplifier and the output amplifier are disabled, the serial control switch is turned off, and a radio frequency input signal is transmitted via the bypass circuit to the output end.

According to a second aspect of embodiments of the present invention, a radio frequency front-end module is provided, including the foregoing low noise amplifier.

According to a third aspect of embodiments of the present invention, a radio frequency signal transmission control method for the foregoing radio frequency front-end module is provided, including the following steps:
controlling an input coupling switch to be turned on, to allow a radio frequency signal to be inputted to an input end of an input amplifier;
controlling a plurality of inter-stage switches to be turned on, to control one or more amplification units in the input amplifier to separately amplify the inputted radio frequency signal, and input the radio frequency signal amplified by the amplification unit to an input end of a load circuit;
controlling the on/off of a bias circuit of each amplification unit;
controlling the on/off of a bypass circuit;
controlling a variable inductor, a variable capacitor, and a variable resistor in the load circuit, to provide load impedance having a particular frequency response; and
controlling a turn-on path of an output change-over switch.

Further, a drain of a transistor of each amplification unit is coupled to a corresponding inter-stage switch, and when the inter-stage switch corresponding to the transistor is turned on, the transistor is turned on, and the inputted radio frequency signal is amplified by the transistor.

The radio frequency signal is inputted to the input end of the load circuit via the inter-stage switch, and an output voltage is generated at an output end of the load circuit.

Further, different amplification gains of the radio frequency signal are implemented by controlling different combinations of the inter-stage switches that are either turned on or off, an impedance feature presented by the load circuit, and the on/off of the bypass circuit.

According to a fourth aspect of embodiments of the present invention, a mobile terminal is provided. A radio frequency front-end module in the mobile terminal includes the foregoing low noise amplifier.

Compared with conventional technologies, in the low noise amplifier provided in the present invention, a plurality of input amplifiers and a plurality of input coupling switching transistors are used, so that high isolation between input ports is achieved, while reducing the area occupied by circuits. Different gain modes of the low noise amplifier are implemented by breaking down each input amplifier into a plurality of amplification units and inter-stage switches connected to the amplification units and controlling different combinations of the inter-stage switches to be turned on. Sharing at least one output amplifier can ensure a high gain and high isolation of the low noise amplifier and minimize the area of the circuit. Each corresponding output amplifier includes a configurable load circuit. Impedance of the load circuit can be adjusted based on different gain mode requirements and frequency band requirements of an inputted signal, to optimize performance.

### BRIEF DESCRIPTION OF THE DRAWINGS

FIG. 1 is a schematic diagram of a low noise amplifier provided in an embodiment of the present invention being used in a radio frequency signal receive path;
FIG. 2A is a schematic diagram of a structure of a low noise amplifier in Embodiment 1 of the present invention;
FIG. 2B is a schematic diagram of a load circuit of a low noise amplifier in Embodiment 1 of the present invention;
FIG. 2C is a first schematic diagram of a bias circuit of a low noise amplifier in Embodiment 1 of the present invention;
FIG. 2D is a second schematic diagram of a bias circuit of a low noise amplifier in Embodiment 1 of the present invention;
FIG. 3 is a schematic diagram of a circuit of a low noise amplifier in Embodiment 2 of the present invention, where transistors in all amplification units share one single grounded degeneration inductor;
FIG. 4A is a schematic diagram of a high-gain operation mode of a low noise amplifier in Embodiment 2 of the present invention;
FIG. 4B is a schematic diagram of a low-gain operation mode of a low noise amplifier in Embodiment 2 of the present invention;
FIG. 5 is a schematic diagram of a circuit of a low noise amplifier in Embodiment 3 of the present invention, where grounded degeneration inductors of transistors in amplification units are independent to each other;
FIG. 6 is a schematic diagram of a circuit of a low noise amplifier in Embodiment 4 of the present invention, where transistors in amplification units in input amplifiers share one single grounded degeneration inductor;
FIG. 7A is a schematic diagram of a circuit of a low noise amplifier in Embodiment 5 of the present invention;
FIG. 7B is a schematic diagram of an input coupling switch of a low noise amplifier in Embodiment 3 and Embodiment 5 of the present invention;
FIG. 8A is a schematic diagram of a high-gain operation mode of a low noise amplifier in Embodiment 5 of the present invention;
FIG. 8B is a schematic diagram of a low-gain operation mode of a low noise amplifier in Embodiment 5 of the present invention;
FIG. 9A is a schematic diagram of a circuit of a low noise amplifier in Embodiment 6 of the present invention;
FIG. 9B is a schematic diagram of an input coupling switch of a low noise amplifier in Embodiment 3 and Embodiment 6 of the present invention;
FIG. 10A is a schematic diagram of a high-gain operation mode of a low noise amplifier in Embodiment 6 of the present invention;
FIG. 10B is a schematic diagram of a low-gain operation mode of a low noise amplifier in Embodiment 6 of the present invention;
FIG. 10C is a schematic diagram of another low-gain operation mode of a low noise amplifier in Embodiment 6 of the present invention;
FIG. 11 is a schematic diagram of a structure of a low noise amplifier in Embodiment 7 of the present invention;
FIG. 12 is a schematic diagram of a circuit of a low noise amplifier in Embodiment 8 of the present invention;
FIG. 13 is a schematic diagram of a low-gain operation mode of a low noise amplifier in Embodiment 8 of the present invention;
FIG. 14A is a schematic diagram of an embodiment of a radio frequency front-end module using a low noise amplifier provided in the present invention;
FIG. 14B is a schematic diagram of another embodiment of a radio frequency front-end module using a low noise amplifier provided in the present invention; and
FIG. 15 is a schematic diagram of a mobile terminal using a low noise amplifier provided in the present invention.

### DETAILED DESCRIPTION

The following describes technical content of the present invention in detail with reference to the accompanying drawings and specific embodiments.

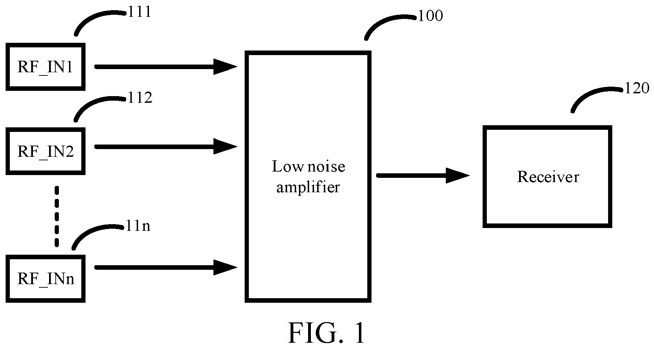

FIG. 1 shows a scenario in which a low noise amplifier provided in an embodiment of the present invention is used in a radio frequency signal receive path. Radio frequency input signals RF_IN 1, RF_IN 2, ..., and RF_IN n (where n is a positive integer greater than or equal to 2, and the same applies below) from a plurality of paths are connected to a low noise amplifier 100 provided in the embodiment of the present invention via an appropriate input matching network (not shown in FIG. 1). An output end of the low noise amplifier 100 is connected to a receiver 120 of radio frequency signals. The amplification of a radio frequency input signal on a particular path is determined by a control signal received by the low noise amplifier 100 to generate a plurality of different gains. Based on the strength of the received signal, an amplification factor of the low noise amplifier 100 may be configured as an appropriate gain value, to ensure a sufficiently high gain in case of a weak signal so as to implement a signal-to-noise ratio required for a system, and ensure a sufficiently low gain in case of a strong signal to prevent distortion of an amplified signal.

There may be a plurality of circuit implementations for the foregoing low noise amplifier 100. Specifically, the low noise amplifier 100 may include: a plurality of input amplifiers and a plurality of radio frequency signal input ends, where a quantity of the input amplifiers is greater than or equal to a quantity of the radio frequency signal input ends;
a plurality of input coupling switches, where two ends of each input coupling switch are respectively connected to one radio frequency signal input end and an input end of one input amplifier, and when the input coupling switch is turned on, a radio frequency signal is transmitted to an input end of a corresponding input amplifier via the input coupling switch;
each input amplifier includes at least two amplification units, and control ends of the amplification units are connected together to form an input end of the input amplifier; when turned on, each amplification unit receives and amplifies a radio frequency signal transmitted to the control end of the amplification unit; and an output end of each amplification unit is connected to a corresponding inter-stage switch, and an amplification gain varies at least partially depending on a combination of the inter-stage switches that are either turned on or off; and
a plurality of inter-stage switches, where one end of each inter-stage switch is connected to an output end of a corresponding amplification unit in each input amplifier, and the other ends of the inter-stage switches are connected together to form a common end. The plurality of inter-stage switches each include a transistor. A gate of the transistor is connected to an independent control voltage. The on or off of the switch depends on the magnitude of the control voltage.

In the technical solutions of embodiments of the present invention, each output amplifier in the low noise amplifier 100 may include:
a configurable load circuit, where an output end of the load circuit is connected to an output end of the low noise amplifier 100 via an output matching circuit, and the other end of the load circuit is connected to a power source; and the load circuit includes a variable inductor, a variable resistor, and a variable capacitor, and a resonant frequency of the load circuit is adjusted and different output impedance is provided by changing capacitance of the variable capacitor and resistance of the variable resistor; and
a driving circuit, where one end of the driving circuit is connected to the common end of the inter-stage switches, and the other end of the driving circuit is connected to the output end of the load circuit. The driving circuit includes at least one transistor. The transistor has a drain connected to the output end of the load circuit, and a source connected to the common end of the plurality of inter-stage switches. A gate of the transistor is connected to a control voltage. A value of the control voltage is selected depending on an operating state and performance of the low noise amplifier 100.

**In** the technical solutions of embodiments of the present invention, two ends of each input coupling switch are respectively connected to a radio frequency signal input end and an input end of one input amplifier. When the input coupling switch is turned on, a radio frequency signal is transmitted to an input end of a corresponding input amplifier via the input coupling switch.

When a radio frequency signal of a particular input end needs to be amplified, the input coupling switch connected to the input end is turned on, a control voltage of a corresponding input amplifier is greater than a threshold voltage of the input amplifier to enable an amplification function of the input amplifier, and remaining input amplifiers are disabled. An amplification factor (gain) partially depends on the quantity of the plurality of inter-stage switches that are connected to the input amplifier and that are turned on.

Each input coupling switch includes at least one serial capacitor and a parallel shunt switch on a signal path. When the input coupling switch is turned on, the parallel shunt switch is turned off, and a radio frequency signal is transmitted to the input end of the input amplifier and amplified. When the input coupling switch is turned off, the parallel shunt switch is turned on and grounded, and the signal path does not amplify an inputted signal.

The input coupling switch further includes a serial switch or a parallel switch resistance branch, or a combination thereof on the signal path. When the input coupling switch is turned on, a radio frequency signal is transmitted to the input end of the input amplifier and amplified, and a switch in the parallel switch resistance branch is on in at least one gain mode. When the input coupling switch is turned off, the serial switch is turned off, the parallel shunt switch is turned on and grounded, and the signal path does not amplify a signal.

**In** the technical solutions of embodiments of the present invention, the input amplifiers each include a same quantity of amplification units. Control ends of the amplification units in a same input amplifier are connected together and share one single bias voltage. Different amplifiers are connected to different independent bias voltages. Output ends of corresponding amplification units in each amplifier are connected together, and are connected to an input end of a same inter-stage switch.

Each amplification unit includes at least one transistor that primarily functions to provide a gain. A radio frequency signal is transmitted to a gate of the transistor. The gate is also the control end of the amplification unit. When both the transistor and the inter-stage switch connected to the transistor are turned on, the radio frequency signal is amplified by the transistor and is coupled to a corresponding inter-stage switch by a drain of the transistor. A source of the transistor is coupled to ground via a degeneration inductor.

The amplification units in each input amplifier may be of a same size or of different sizes in a particular ratio. Sizes of corresponding amplification units in different input amplifiers may be the same or different. Quantities and a specific ratio of the amplification units depend on a specific gain level.

In the technical solutions of embodiments of the present invention, when a radio frequency signal of a particular radio frequency signal input end needs to be amplified, a control voltage of a corresponding input amplifier is greater than a threshold voltage of the input amplifier to enable an amplification function of the input amplifier, and remaining input amplifiers are disabled. An amplification factor (gain) partially depends on the quantity of the plurality of inter-stage switches that are connected to the input amplifier and that are turned on.

In the technical solutions of embodiments of the present invention, the low noise amplifier 100 may further include at least one bypass circuit. One end of the bypass circuit is connected to an output end of the low noise amplifier 100, and the other end of the bypass circuit is connected to an input end of one input amplifier. At least one serial control switch is connected between an output end of a load circuit and the output end of the low noise amplifier 100. When the bypass circuit is enabled, the input amplifier and the output amplifier 150 are disabled, the foregoing serial control switch is turned off, and a radio frequency input signal is transmitted via the foregoing bypass circuit to the output end.

The foregoing bypass circuit may include a passive network with at least one switch and at least one capacitor. The passive network may be a parallel network, a T-network, or a Pi-network. The amplification unit is not limited to an inductor or a capacitor, and may alternatively be a resistor, a transformer, a balun, or the like. In addition, the passive network forms an output matching network, to optimize performance of the bypass circuit.

The following describes specific technical details of the present invention in detail by using different embodiments.

### Embodiment 1:

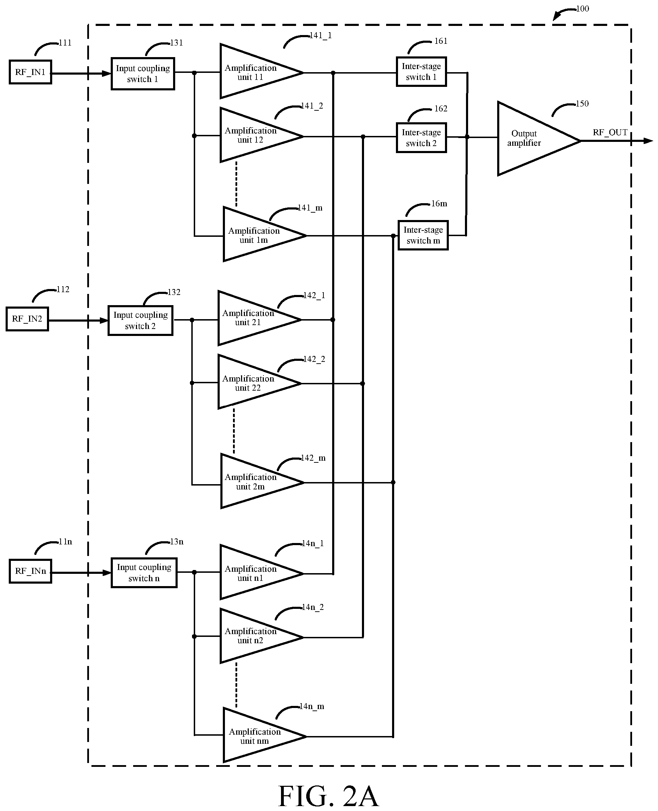

As shown in FIG. 2A, a low noise amplifier 100 provided in Embodiment 1 of the present invention includes a plurality of radio frequency signal input ends RF_IN1, RF_IN2, ..., and RF_INn. The first radio frequency signal input end RF_IN1 is connected to one end of a first input coupling switch 131, and the other end of the first input coupling switch 131 is connected to an input end of a first input amplifier. The first input amplifier includes m (where m is a positive integer greater than or equal to 2, and the same applies below) amplification units, which are amplification units 141_1, 141_2, ..., and 141_m. Input ends of the m amplification units are connected together to form the input end of the first input amplifier. Further, the first amplification unit 141_1 in the first input amplifier is connected to a first end of a first inter-stage switch 161. The second amplification unit 141_2 in the first input amplifier is connected to a first end of a second inter-stage switch 162. By analogy, the m^{th} amplification unit 141_m in the first input amplifier is connected to a first end of an m^{th} inter-stage switch 16m.

Similarly, the n^{th} radio frequency signal input end RF_INn is connected to one end of an n^{th} input coupling switch 13n, and the other end of the n^{th} input coupling switch 13n is connected to an input end of an n^{th} input amplifier. The n^{th} input amplifier includes m amplification units, which are amplification units 14n_1, 14n_2, ..., and 14n_m. Input ends of the m amplification units are connected together to form the input end of the n^{th} amplifier. Further, the first amplification unit 14n_1 in the n^{th} input amplifier is connected to the first end of the first inter-stage switch 161. The second amplification unit 14n_2 in the n^{th} input amplifier is connected to the first end of the second inter-stage switch 162. By analogy, the m^{th} amplification unit 14n_m in the n^{th} input amplifier is connected to the first end of the m^{th} inter-stage switch 16m.

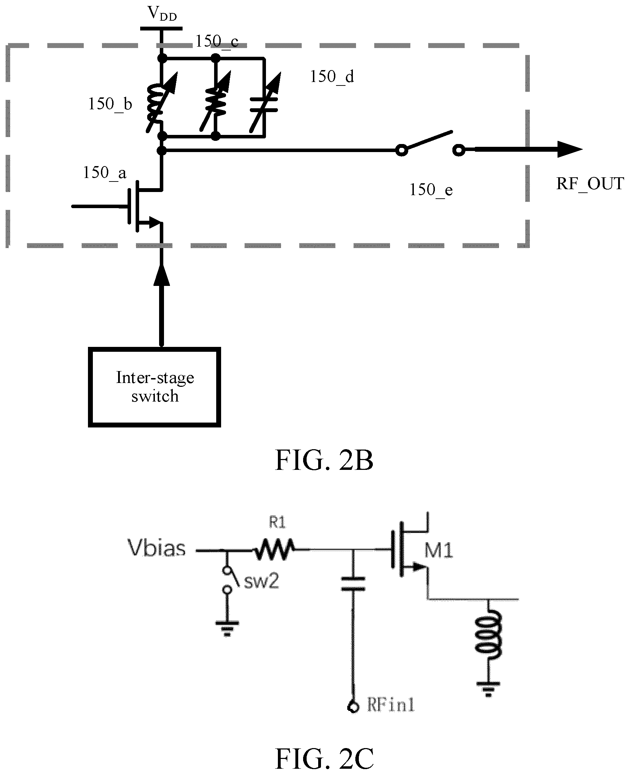

Second ends of the foregoing m inter-stage switches are connected together to form a common end. The common end is further connected to an input end of an output amplifier 150. The output amplifier 150 includes a driving circuit and a load circuit shown in FIG. 2B. An output voltage is generated at a junction of the driving circuit and the load circuit. The driving circuit has an independent control voltage. The configurable load circuit provides an impedance feature having a particular frequency response. Each input amplifier coverts an inputted weak radio frequency signal into an amplified radio frequency signal, and an output voltage is generated at an output end of the load circuit via the output amplifier 150. At first-order approximation, a gain of the low noise amplifier 100 is obtained by a product of equivalent transconductance of the input amplifiers and impedance of an output end. In the technical solutions of embodiments of the present invention, which amplification units in each input amplifier perform amplification is specifically determined by an inter-stage switch 1, an inter-stage switch 2, ..., and an inter-stage switch m. The particular amplification units to be enabled in each input amplifier can be determined by choosing different combinations of the m inter-stage switches to be turned on or off, and equivalent transconductance of the input amplifiers in corresponding conditions is thus determined. In addition, selecting appropriate parameters of electronic components in the configurable load circuit to present appropriate impedance can implement a required gain mode.

As shown in FIG. 2B, the load circuit in the low noise amplifier 100 includes a driving transistor 150_a, a variable inductor 150_b, a variable capacitor 150_d, a variable resistor 150_c, and a switch 150_e. The variable inductor 150_b, the variable capacitor 150_d, and the variable resistor 150_c are connected in parallel to form a configurable load circuit. The driving transistor 150_a has a source connected to the inter-stage switches, and a drain connected to the configurable load circuit. The switch 150_e is connected between the drain of the driving transistor 150_a and a radio frequency signal output end RF_OUT in series.

In addition, each input amplifier in the low noise amplifier 100 includes a bias circuit providing a bias voltage Vbias for the input amplifier.

In an embodiment of the bias circuit shown in FIG. 2C, the bias voltage Vbias is connected to a gate of a transistor M1 via a resistor R1. Because a radio frequency signal Rfin1 is also coupled to the gate of the transistor M1, the resistor R1 functions as a radio frequency choke (RF choke), to prevent crosstalk of the radio frequency signal to the bias circuit. To enable the transistor M1, a switch SW2 is turned off, the bias voltage is greater than a threshold voltage of the transistor M1, and the transistor M1 enters an operating state. To disable the transistor M1, the switch SW2 is turned on and grounded. Zero potential is transferred to the gate of the transistor M1 via the resistor R1. Because the zero potential is less than the threshold voltage of the transistor M1, and the transistor M1 cannot be turned on, the transistor is disabled.

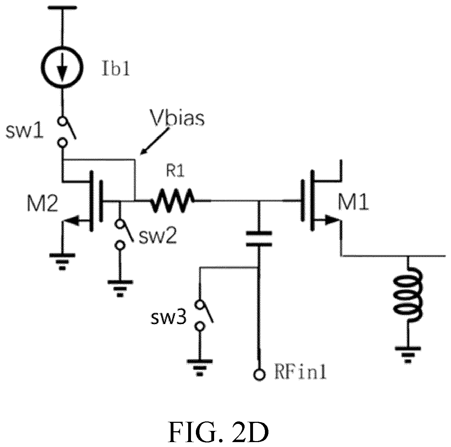

In another embodiment of the bias circuit shown in FIG. 2D, a bias voltage is provided for the transistor M1 by using a current mirror (including a transistor M1 and a transistor M2). A drain and a gate of the transistor M2 are connected together in a diode connection mode. When a bias current Ib1 passes through the transistor M2, a bias voltage Vbias is generated at the gate of the transistor and is connected to the transistor M1 via a resistor R1, and the current Ib1 passes through the transistor M1. In this way, a size ratio relation of the transistor M2 is mirrored to the transistor M1. Because a radio frequency signal RFin1 is also coupled to a gate of the transistor M1, the resistor R1 functions as a radio frequency choke, to prevent crosstalk of the radio frequency signal to the bias circuit. When the transistor M1 needs to be enabled, a switch SW1 is turned on, and a switch SW2 and a switch SW3 are turned off. In this case, the bias current Ib1 passes through the transistor M2, the transistor M2 is in a diode connection mode, the bias voltage Vbias is generated at the gate, and the transistor M1 is enabled after obtaining a current. When the transistor M1 needs to be disabled, the switch SW2 and the switch SW3 are turned on, and the switch SW1 is turned off. In this case, the bias current Ib1 cannot pass through the transistor M2, the gate of the transistor M2 is pulled to ground by the switch SW2, zero potential is transferred to the gate of the transistor M1 via the resistor R1, and the transistor M1, which is unable to obtain a current, is disabled. In this case, there is no bias voltage because the transistor M2 generating the Vbias does not work. In the foregoing design of the bias circuit, the switch SW2 of a ground branch is connected between the gate of the transistor M2 and the resistor R1, and is not directly connected to the gate of the transistor M1. Therefore, parasitic capacitance of the switch does not affect performance of the transistor M1 during operation. One end of the resistor R1 is directly connected to a Vbias end, without any serial switch therebetween. The switch SW1 is connected on a branch of a current source Ib1 in series. When the transistor M1 is disabled, the switch SW1 is turned off, and there is no bias voltage Vbias, so that power can be saved.

It can be learned from FIG. 2A that in the technical solutions of embodiments of the present invention, a quantity of the amplifiers may be different from a quantity of radio frequency signals to be amplified, and the amplification units do not need to be in one-to-one correspondence with the radio frequency signals to be amplified. In addition, in embodiments of the present invention, amplification of a plurality of radio frequency input signals can be implemented. Frequencies of these radio frequency input signals may be different or partially the same. In addition, a person skilled in the art may understand that output matching circuits may be provided between the output end of the load circuit and the radio frequency signal output end of the low noise amplifier. These output matching circuits may be a network including an inductor, a capacitor, and a resistor, such as a T-network, a Pi-network, or an L-network. The foregoing output matching circuit is a conventional design generally mastered by a person skilled in the art. Details are not described herein.

### Embodiment 2:

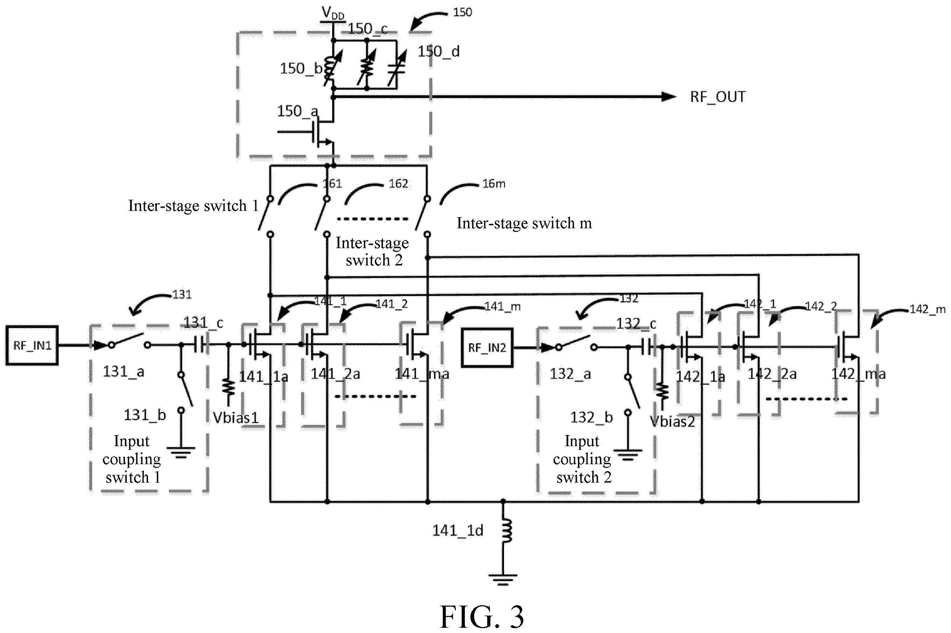

As shown in FIG. 3, in Embodiment 2 of the present invention, a low noise amplifier 100 includes two radio frequency signal input ends RF_IN1 and RF_IN2 and two corresponding radio frequency amplification paths. A first radio frequency amplification path includes the radio frequency signal input end RF_IN1, an input coupling switch 131, a first input amplifier, m inter-stage switches, and an output amplifier 150. A second radio frequency amplification path includes the radio frequency signal input end RF_IN2, an input coupling switch 132, a second input amplifier, the m inter-stage switches, and the output amplifier 150. The input coupling switch 131 has a same internal structure as the input coupling switch 132. The input coupling switch 131 is used as an example herein. An input end of the input coupling switch 131 is connected to a first end of a first switch 131_a. A second end of the first switch 13 1_a is connected to a first end of a capacitor 131_c. A second end of the capacitor 13 1_c forms an output end of the input coupling switch 131. The second end of the first switch 131_a is connected to a first end of a second switch 13 1_b. A second end of the second switch 131_b is grounded. The output amplifier 150 includes a driving transistor 150_a and a configurable load circuit. The configurable load circuit in Embodiment 2 may include a variable inductor 150_b, a variable capacitor 150_d, and a variable resistor 150_c.

In Embodiment 2, the first input amplifier includes m amplification units, that is, a transistor 141_1, a transistor 141_2, ..., and a transistor 141_m. The radio frequency signal input end RF_IN1 is connected to the input end of the input coupling switch 131. The output end of the input coupling switch 131 is connected to gates of the m transistors (141_1, 141_2, ..., and 141_m). The gates are also control ends of the amplification units. A drain of the transistor 141_1 in a first amplification unit is connected to a first end of an inter-stage switch 161. A drain of the transistor 141_2 in a second amplification unit is connected to a first end of an inter-stage switch 162. By analogy, a drain of the transistor 141_m in an m^{th} amplification unit is connected to a first end of an inter-stage switch 16m. A source 141_1a of the transistor 141_1, a source 141_2a of the transistor 141_2, ..., and a source 141_ma of the m^{th} transistor 141_m are connected together and are grounded via a degeneration inductor 141_1d. Second ends of the foregoing m inter-stage switches are connected together and connected to a source of the driving transistor 150_a. A drain of the driving transistor 150_a is connected to an output end of the configurable load circuit, and is further drawn out to a radio frequency signal output end RF_OUT. The other end of the configurable load circuit is connected to a power source VDD.

By analogy, the second input amplifier includes m amplification units, that is, a transistor 142_1, a transistor 142_2, ..., and a transistor 142_m. The radio frequency signal input end RF_IN2 is connected to an input end of the input coupling switch 132. An output end of the input coupling switch 132 is connected to gates of the m transistors (142_1, 142_2, ..., and 142_m). The gates are also control ends of the amplification units. A drain of the transistor 142_1 in a first amplification unit is connected to the first end of the inter-stage switch 161. A drain of the transistor 142_2 in a second amplification unit is connected to the first end of the inter-stage switch 162. A drain of the transistor 142_m in an m^{th} amplification unit is connected to the first end of the inter-stage switch 16m. In addition, a source 142_1a of the transistor 142_1, a source 142_2a of the transistor 142_2, ..., and a source 142_ma of the m^{th} transistor 142_m are connected together and are grounded via the degeneration inductor 141_1d.

A person skilled in the art may understand that the foregoing descriptions of embodiments of the low noise amplifier 100 does not cover all details about electronic circuits. For example, the input amplifier may be provided with the bias circuit shown in FIG. 2C or FIG. 2D to maintain an appropriate operating state. In the foregoing embodiment, a bias circuit is represented by bias voltages Vbias1 and Vbias2 respectively connected to the gates of the amplification transistors via resistors. The on or off of the input amplifier as well as an operational quiescent current of the input amplifier when enabled depend on the magnitude of the bias voltage. In addition, a gate of the driving transistor 150_a may alternatively be provided with a bias voltage and a corresponding decoupling capacitor, to control an operating state of the transistor. Adjustment of the foregoing bias voltage and the like are conventional designs generally mastered by a person skilled in the art. Details are not described herein.

In practice, because the low noise amplifier 100 needs to operate in different application scenarios, strength of a received signal dynamically varies in a wide range. This requires the low noise amplifier 100 to be capable of providing a plurality of gain modes, to meet different signal amplification requirements. For example, a mobile phone requires that a gain of the low noise amplifier 100 ranges from -15 dB to 25 dB currently. A negative gain herein indicates that the gain needs to be attenuated. To support a plurality of communications standards and communication platforms, the low noise amplifier 100 further needs to have at least ten different gain modes. In addition, when the gain is reduced, the operational quiescent current of the low noise amplifier 100 needs to significantly decrease compared to when the gain is high. Detailed description is provided below.

At first-order approximation, a gain of the low noise amplifier 100 may be expressed as a product of equivalent transconductance (Gm) of an input end of the low noise amplifier and load impedance (Z_{load}) of an output end, that is, the gain G equals to Gm*Z_{load}. Further, at square law approximation of curves of transistors I to V, Gm is in direct proportion to sqrt(W/L*Ic). W is a width of the amplification transistor, Ic is an operational quiescent current passing through the amplification transistor, and L is a length of the amplification transistor. The expression herein does not include factors related to a manufacturing process, and the length L is typically chosen to be a minimum value that the manufacturing process allows, or a particular fixed value. The operational quiescent current of the amplification transistor is usually obtained by mirroring the current in the bias circuit, that is, Ic=(W/Wo)*Io. Io is a source current in the bias circuit, Wo is a width of a source current transistor, and W is the width of the amplification transistor. Therefore, Gm is in direct proportion to W.

In conclusion, the following calculation equation may be obtained. The gain G equals to Gm*Z_{load} and is in direct proportion to W*Z_{load}. The total operational quiescent current Ic is in proportion to W, where W is the width of the transistor.

Compared with conventional technologies, in the present invention, one amplification transistor is broken down into transistors in a plurality of amplification units of small sizes, and drains of the transistors are respectively connected to inter-stage switches controlled independently. Only when the inter-stage switch connected to a transistor is turned on, an amplification function of the transistor in a corresponding amplification unit is enabled, and a width W of the transistor is considered in calculation of the foregoing equation of the gain and the current. It can be learned that in the present invention, an effective width of the amplification transistor is dynamically adjusted, to implement a plurality of gain modes and meet the requirement of low power consumption. Compared with the method of changing load impedance or changing a degeneration inductor of a source of an amplification transistor commonly used in conventional technologies, the technical solutions used in the present invention have distinctive advantages that low power consumption is easy to be implemented, differences between different gain modes are less likely to change with variations of a wafer manufacturing process corner, and so on.

For example, if each input amplifier includes three amplification units (that is, m=3), and sizes (widths) of the amplification units are selected as W1, 2*W1, and 4*W1, based on different combinations in which three inter-stage switches are turned on, there is a total of seven different effective sizes. A relationship between the operational quiescent current and the theoretical gain is shown in the following Table 1. Herein, "1" represents on, and "0" represent off.

**Table 1**

| Gain mode | Inter-stage switch 3 | Inter-stage switch 2 | Inter-stage switch 1 | Effective total width of the transistor | Effective operational quiescent current of the transistor is in direct proportion to | Theoretical gain is in direct proportion to |
|---|---|---|---|---|---|---|
| G7 | 1 | 1 | 1 | 7*W1 | 7*W1 | 7*W1*Z_{load} |
| G6 | 1 | 1 | 0 | 6*W1 | 6*W1 | 6*W1*Z_{load} |
| G5 | 1 | 0 | 1 | 5*W1 | 5*W1 | 5*W1*Z_{load} |
| G4 | 1 | 0 | 0 | 4*W1 | 4*W1 | 4*W1*Z_{load} |
| G3 | 0 | 1 | 1 | 3*W1 | 3*W1 | 3*W1*Z_{load} |
| G2 | 0 | 1 | 0 | 2*W1 | 2*W1 | 2*W1*Z_{load} |
| G1 | 0 | 0 | 1 | 1*W1 | 1*W1 | 1*W1*Z_{load} |

In practice, because other performance indicators, such as a noise factor, linearity, and input matching, of the low noise amplifier 100 need to be considered, to implement different gain modes, a load, a bias voltage, and the like may need to be changed, so that the relation between the operational quiescent current as well as the gain level and the effective width of the transistor may change. However, such change is still within the expectations of a person skilled in the art.

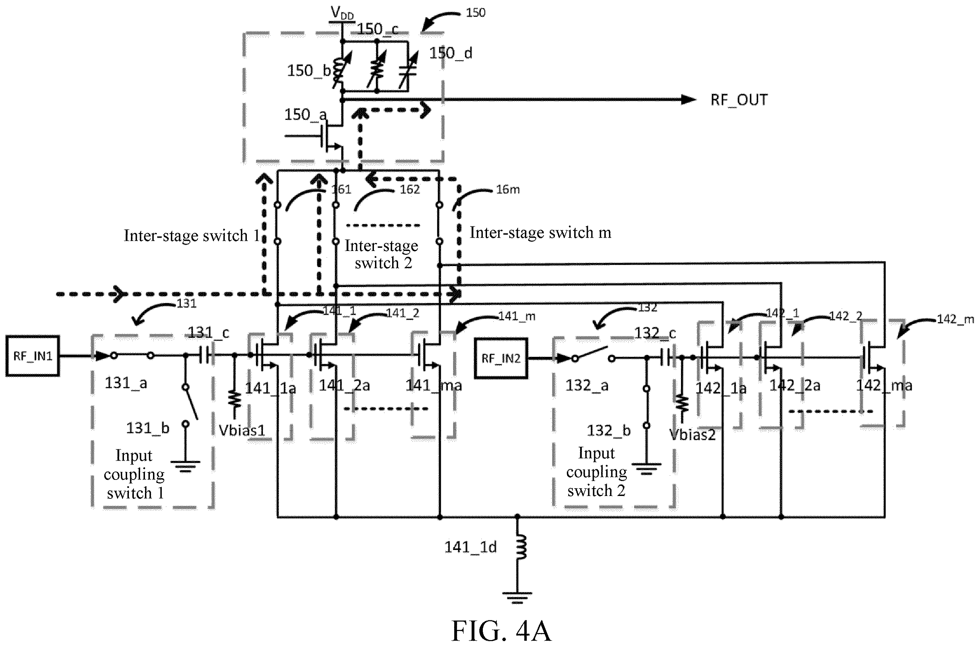

FIG. 4A shows an operating scenario of the low noise amplifier 100 provided in Embodiment 2. In the operating scenario, the low noise amplifier 100 needs to operate in a high-gain mode. As shown in FIG. 4A, a radio frequency signal of a particular frequency band enters the first amplification path from the radio frequency signal input end RF_IN1, and the path is enabled. In this case, the input coupling switch 131 is turned on. Specifically, in the input coupling switch 131, the first switch 131_a is turned on, and the second switch 131_b is turned off. The bias voltage Vbias1 is configured as an appropriate voltage value, and the first input amplifier enters an operating state and has an amplification function. A control voltage of the gate of the driving transistor in the output amplifier 150 is configured as an appropriate voltage value. The m inter-stage switches (161, 162, ..., and 16m) are all turned on. The radio frequency signal is coupled to an input end of the first input amplifier, that is, the gates of the transistors in each amplification unit, via the capacitor 13 1_c in the input coupling switch, and corresponding radio frequency currents are generated by the transistors (141_1, 141_2, ..., and 141_m). The radio frequency currents are outputted from drains of the individual transistors, pass through the inter-stage switches (161, 162, ..., and 16m) that are turned on, converge at a common end of the inter-stage switches, and enter the output amplifier 150. In the output amplifier 150, capacitance of the variable capacitor, inductance of the variable inductor, and resistance of the variable resistor in the configurable load circuit are configured as appropriate values, to achieve impedance features with required frequency responses. After passing through the driving transistor 150_a, the radio frequency signal is converted into a radio frequency voltage signal at the output end of the load circuit, and the radio frequency voltage signal is coupled to the radio frequency signal output end RF_OUT via an output matching circuit (not shown). For a flow path of the foregoing radio frequency signal from the radio frequency signal input end to the radio frequency signal output end, refer to black dashed lines in FIG. 4A.

In a process in which the foregoing radio frequency signal is amplified, the second amplification path may be disabled. To be specific, the input coupling switch 132 is turned off. Specifically, in the input coupling switch 132, a switch 132_a is turned off, and a switch 132_b is turned on and grounded. The bias voltage Vbias2 is configured as power ground (zero potential), and all the amplification transistors (142_1, 142_2, ..., and 142_m) in the second input amplifier are in a cutoff state.

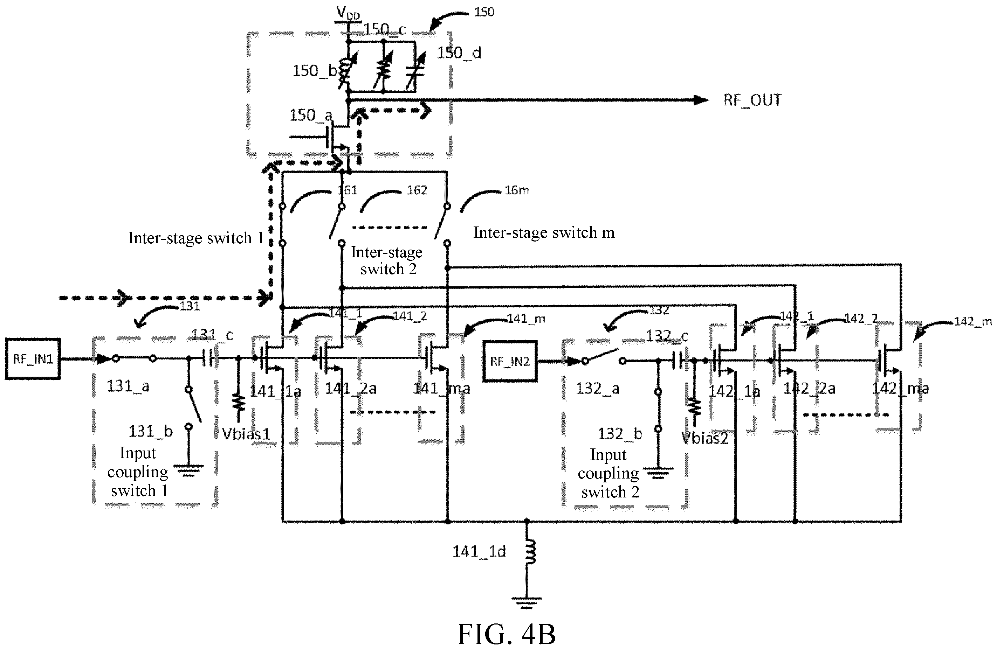

FIG. 4B shows another operating scenario of the low noise amplifier 100 provided in Embodiment 2. In the operating scenario, the low noise amplifier 100 needs to operate in a low-gain mode. As shown in FIG. 4B, a radio frequency signal of a particular frequency band enters the first amplification path from the radio frequency signal input end RF_IN1, and the path is enabled. In this case, the input coupling switch 131 is turned on. Specifically, in the input coupling switch 131, the first switch 13 1_a is turned on, and the second switch 131_b is turned off. The bias voltage Vbias1 is configured as an appropriate voltage value, and the first input amplifier enters an operating state and has an amplification function. A control voltage of the gate of the driving transistor in the output amplifier 150 is configured as an appropriate voltage value. The voltage value may be the same as or different from the corresponding value at a high gain in FIG. 4A. The first inter-stage switch 161 is turned on. The radio frequency signal is coupled to an input end of the first input amplifier via the capacitor 13 1_c in the input coupling switch. Because only the inter-stage switch 161 is turned on, only the transistor 141_1 generates a corresponding radio frequency current. The radio frequency current is outputted from the drain of the transistor, passes through the first inter-stage switch 161, converges at a common end of the first inter-stage switch 161, and enters the output amplifier 150. In the output amplifier 150, capacitance of the variable capacitor, inductance of the variable inductor, and resistance of the variable resistor in the configurable load circuit are configured as appropriate values, to achieve impedance features with required frequency responses. The configured values may be the same as or different from the corresponding values at a high gain in FIG. 4A. After passing through the driving transistor 150_a, the radio frequency signal is converted into a radio frequency voltage signal at the output end of the load circuit, and the radio frequency voltage signal is coupled to the radio frequency signal output end RF_OUT via an output matching circuit (not shown). For a flow path of the foregoing radio frequency signal from the radio frequency signal input end to the radio frequency signal output end, refer to black dashed lines in FIG. 4B. In a process in which the foregoing radio frequency signal is amplified, a state of the second amplification path is the same as the corresponding path in FIG. 4A. Details are not described herein again.

It should be noted that in the first input amplifier and the second input amplifier, sizes of the m transistors may be the same or different. Similarly, in the two input amplifiers, sizes of the transistors in corresponding amplification units may be the same or different. In addition, one particular inter-stage switch or several particular inter-stage switches may be biased at a normally on state (when enabled). A transistor in the amplification unit connected to the inter-stage switch always provides a radio frequency signal, a radio frequency current generated on another path on which the inter-stage switch is turned on is superimposed, and finally, a radio frequency output signal is formed at the output end of the load circuit.

### Embodiment 3:

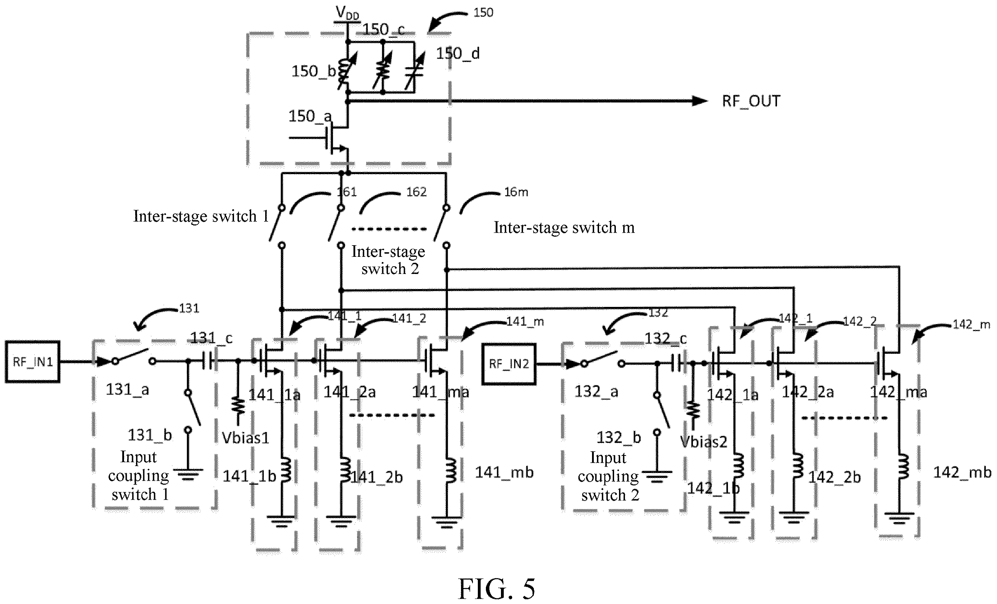

Embodiment 3 shown in FIG. 5 is implemented based on Embodiment 2 by changing the connection of a source of each transistor in each amplification unit in each input amplifier with a degeneration inductor to be coupled to ground. A first input amplifier is used as an example. Sources (141_1a, 141_2a, ..., and 141_ma) of individual transistors (141_1, 141_2, ..., and 141_m) in each amplification unit are each independently connected to one end of one of m degeneration inductors (141_1b, 141_2b, ..., and 141_mb), and the other end of each of the m degeneration inductors is grounded. In a second input amplifier, a source of each transistor in each amplification unit is connected to a degeneration inductor in a similar manner. Inductance of the degeneration inductors may be the same or different depending on design requirements. The connection method of other circuits in Embodiment 3 is the same as that in Embodiment 2. Details are not described herein again.

### Embodiment 4:

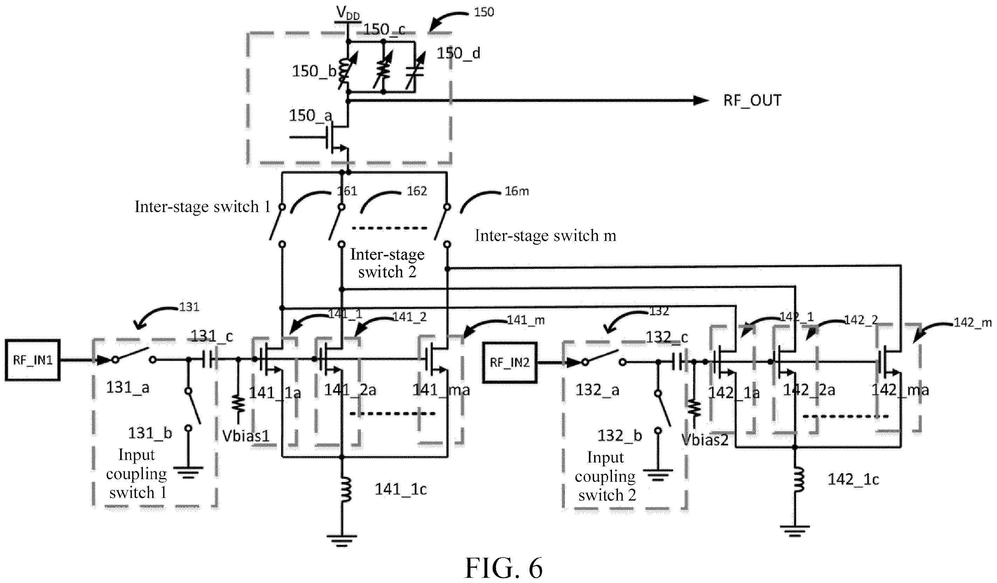

Embodiment 4 shown in FIG. 6 is implemented based on Embodiment 2 by changing the connection of a source of each transistor in each amplification unit in each input amplifier with a degeneration inductor to be coupled to ground. A first input amplifier is used as an example. Sources (141_1a, 141_2a, ..., and 141_ma) of transistors (141_1, 141_2, ..., and 141_m) in each amplification unit are jointly connected to one end of a degeneration inductor 141_1c, and the other end of the degeneration inductor 141_1c is grounded. In a second input amplifier, a source of each transistor in each amplification unit is connected to a degeneration inductor in a similar manner. Therefore, one single degeneration inductor is shared in each input amplifier to ground. Inductance of the degeneration inductors may be the same or different depending on design requirements. The connection method of other circuits in Embodiment 4 is the same as that in Embodiment 2. Details are not described herein again.

It should be noted that a quantity and connection method of the degeneration inductors in the input amplifiers in Embodiment 3 and Embodiment 4 are examples, and there may be another connection method. For example, one single degeneration inductor is shared in the first input amplifier, and independent degeneration inductors are provided for the transistors in individual amplification units in the second input amplifier, or some of the transistors share one degeneration inductor. Details are not described herein again.

### Embodiment 5:

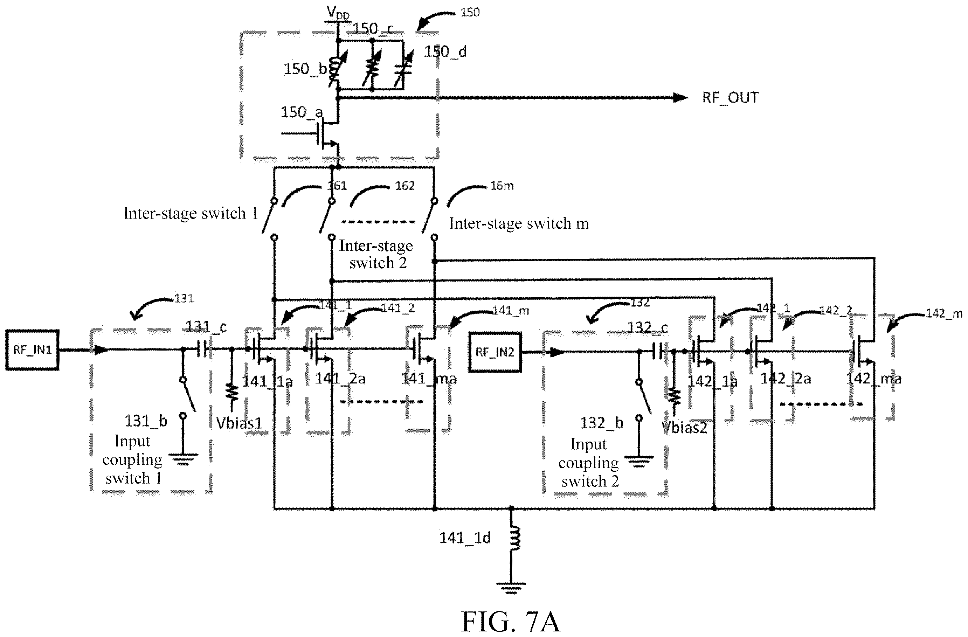

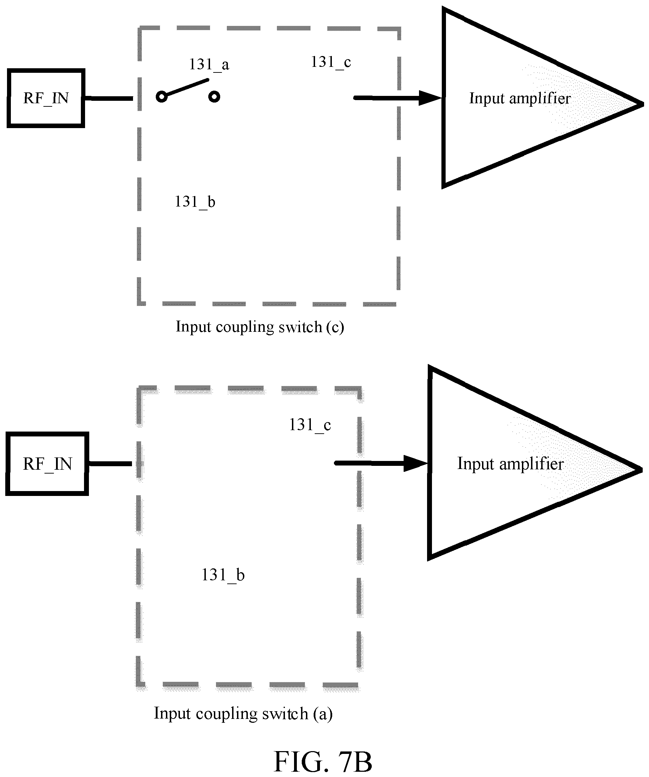

Embodiment 5 shown in FIG. 7A is another embodiment of a low noise amplifier 100. Refer to FIG. 7B. This embodiment is implemented based on Embodiment 2 shown in FIG. 3 by replacing the input coupling switch. The upper section in FIG. 7B shows the input coupling switch in FIG. 3, and the lower section shows an input coupling switch in FIG. 7A. Compared with the upper section in FIG. 7B, a serial switch on a signal path is removed in the input coupling switch replaced with, so that an insertion loss caused by the serial switch is eliminated. Other circuits in FIG. 7A are the same as the corresponding parts in FIG. 3. Details are not described herein again.

It should be noted that similar to Embodiment 3 and Embodiment 4, a quantity and connection method of degeneration inductors via which a source of each transistor in each amplification unit in each input amplifier is coupled to ground in Embodiment 5 may be different.

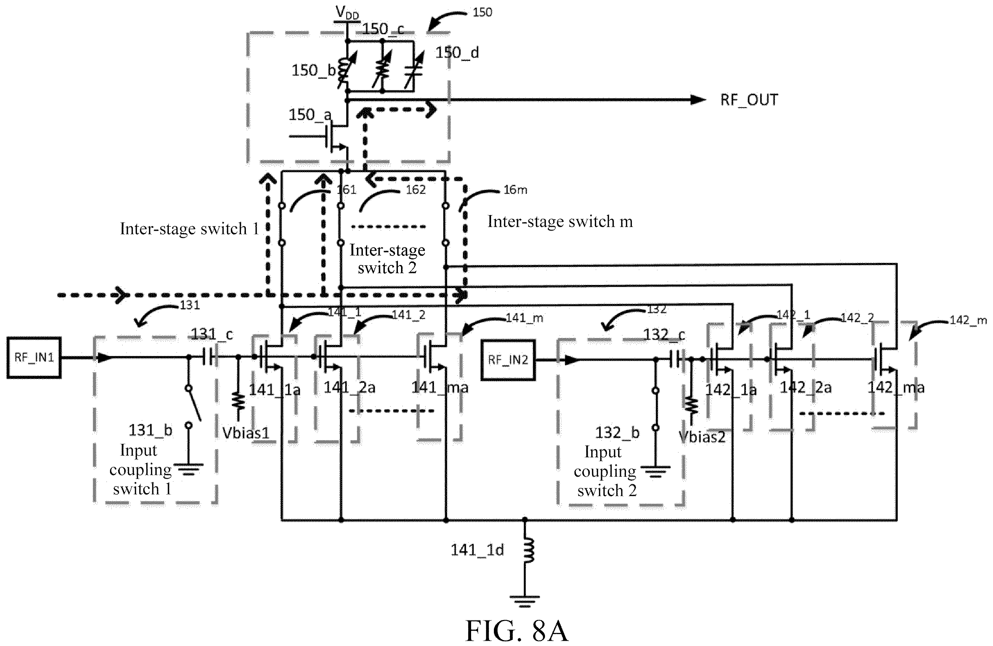

FIG. 8A shows an operating scenario of Embodiment 5. The low noise amplifier 100 operates in a high-gain mode. As shown in FIG. 8A, a radio frequency signal of a particular frequency band enters a first amplification path from a radio frequency signal input end RF_IN1, and the amplification path is enabled. In this case, an input coupling switch 131 is turned on. Specifically, a switch 131_b in the input coupling switch 131 is turned off. Other operating states are the same as the descriptions in FIG. 4A. Details are not described herein again.

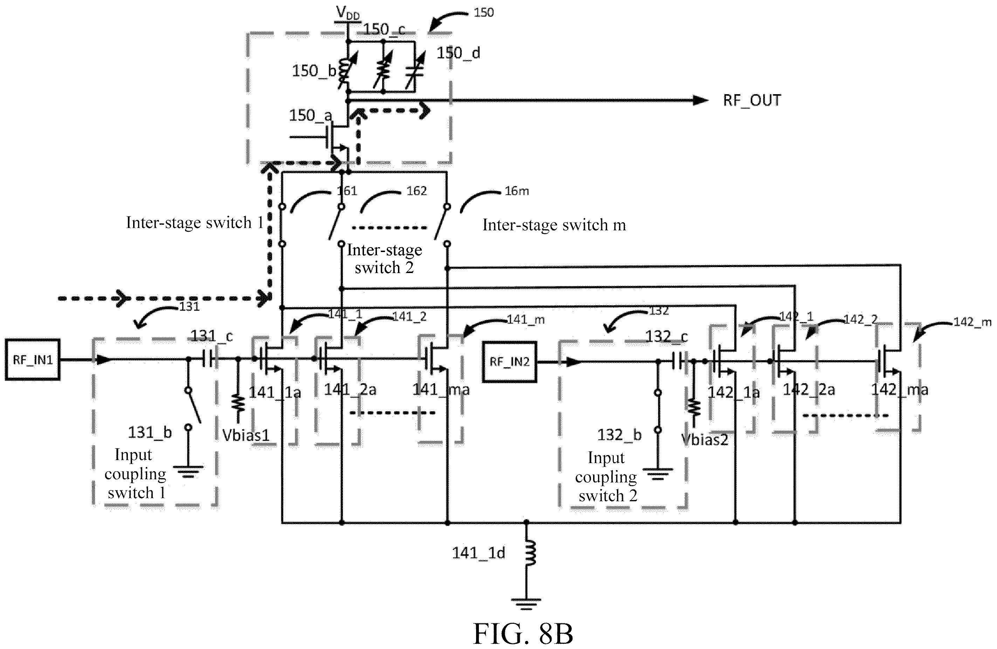

FIG. 8B shows another operating scenario of Embodiment 5. The low noise amplifier 100 operates in a low-gain mode. As shown in FIG. 8B, a radio frequency signal of a particular frequency band enters the first amplification path from the radio frequency signal input end RF_IN1, and the amplification path is enabled. In this case, the input coupling switch 131 is turned on, and the switch 131_b is turned off. Other operating states are the same as the descriptions in FIG. 4B. Details are not described herein again.

### Embodiment 6:

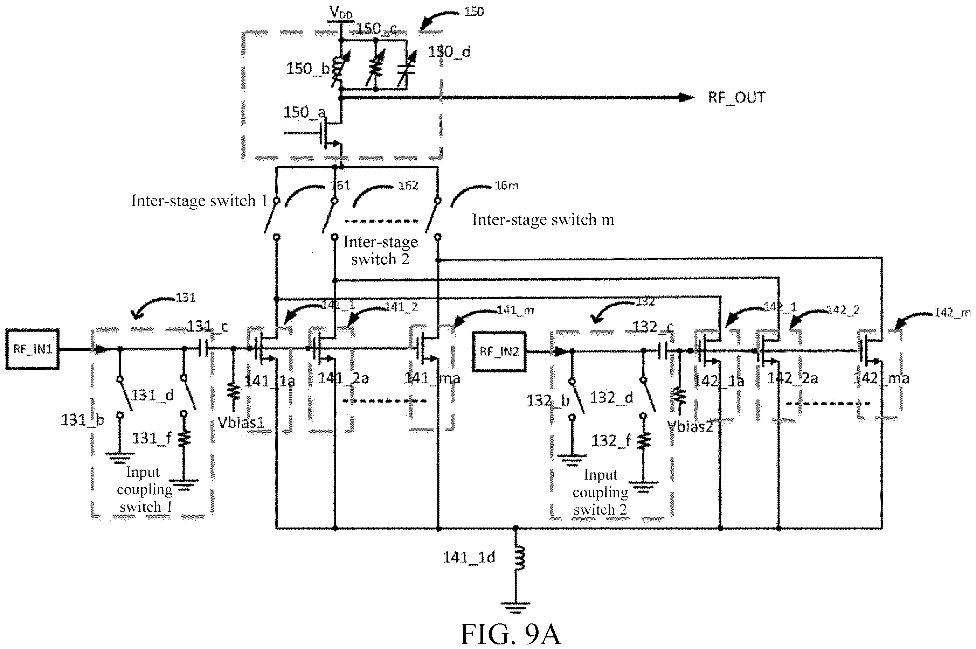

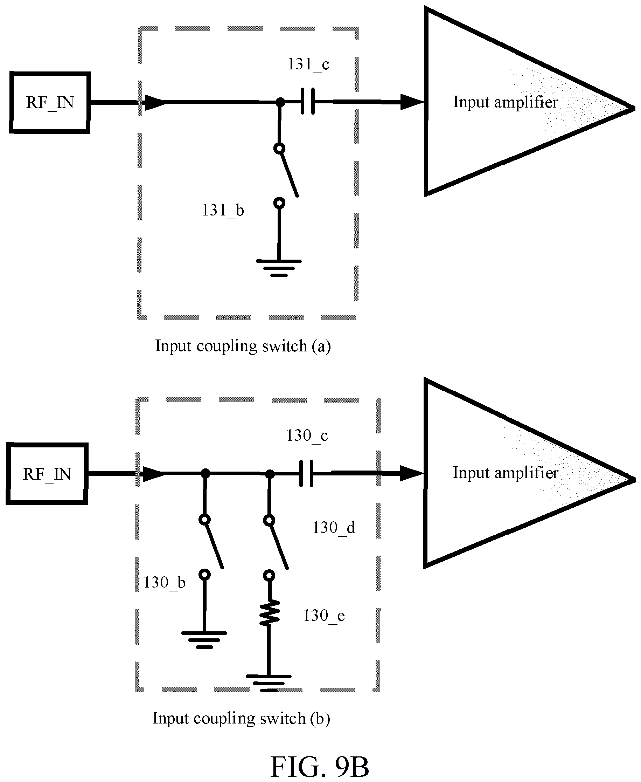

Embodiment 6 shown in FIG. 9A is another embodiment of a low noise amplifier 100. Refer to FIG. 9B. This embodiment is implemented based on Embodiment 2 shown in FIG. 3 by replacing the input coupling switch. The dashed line box in the upper section in FIG. 9B shows the input coupling switch in FIG. 3, and the dashed line box in the lower section shows an input coupling switch in FIG. 9A. Compared with the upper section in FIG. 9B, a serial switch on a signal path is removed in the input coupling switch replaced with, so that an insertion loss caused by the serial switch is eliminated. In addition, a serial switch resistance branch is added to ground. Other circuits in FIG. 9A are the same as the corresponding parts in FIG. 3. Details are not described herein again.

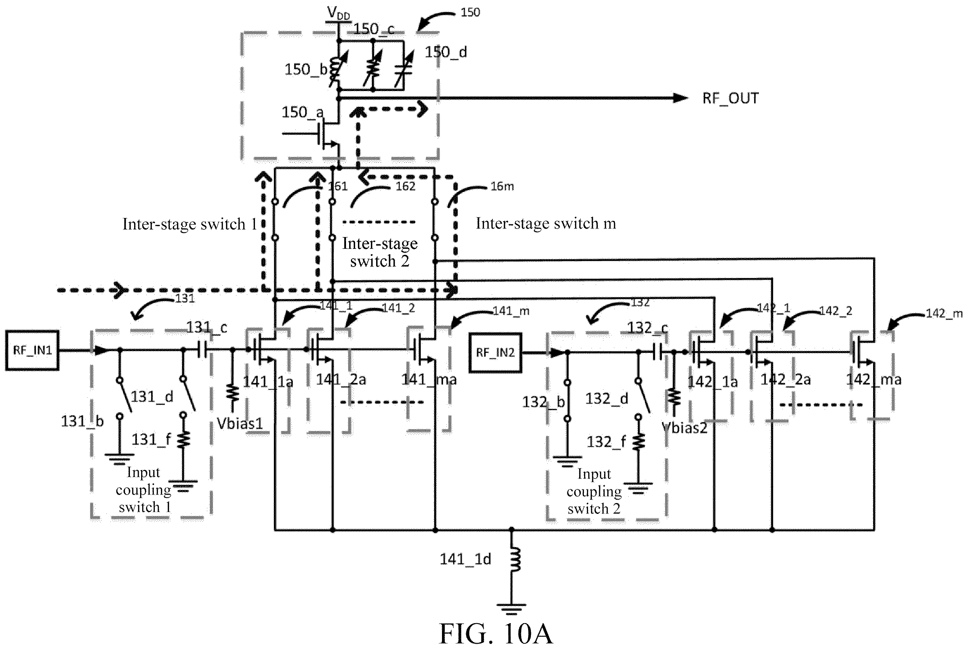

FIG. 10A shows an operating scenario of Embodiment 6. The low noise amplifier 100 operates in a high-gain mode. As shown in FIG. 10A, a radio frequency signal of a particular frequency band enters a first amplification path from a radio frequency signal input end RF_IN1, and the amplification path is enabled. In this case, an input coupling switch 131 is turned on. Specifically, both a switch 131_b and a switch 131_d in the input coupling switch 131 are turned off. Other operating states are the same as the descriptions in FIG. 4A. Details are not described herein again.

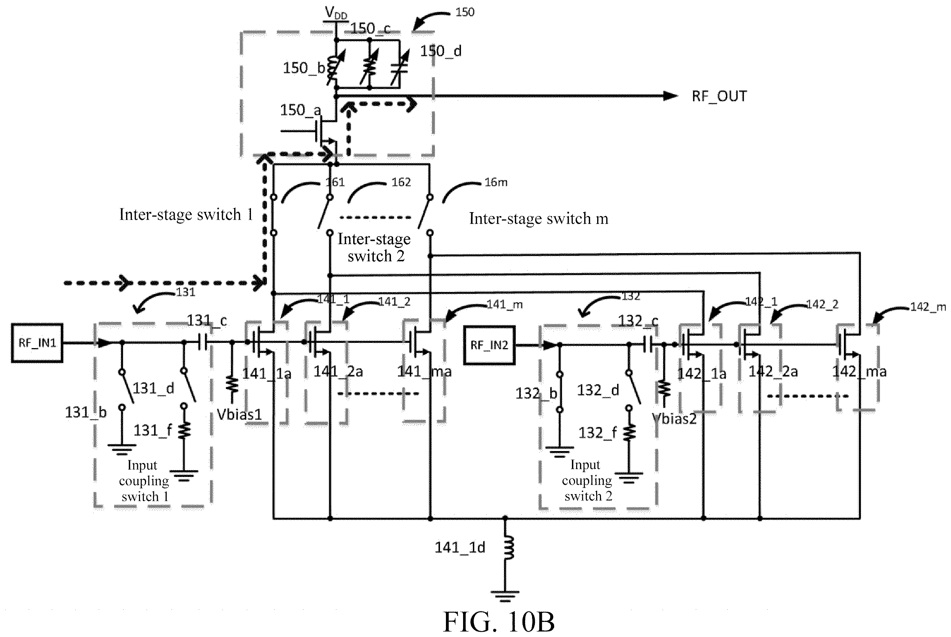

FIG. 10B shows another operating scenario of Embodiment 6. The low noise amplifier 100 operates in a low-gain mode. As shown in FIG. 10B, a radio frequency signal of a particular frequency band enters the first amplification path from the radio frequency signal input end RF_IN1, and the amplification path is enabled. In this case, an input coupling switch 131 is turned on. Specifically, both a switch 131_b and a switch 131_d in the input coupling switch 131 are turned off. Other operating states are the same as the descriptions in FIG. 4B. Details are not described herein again.

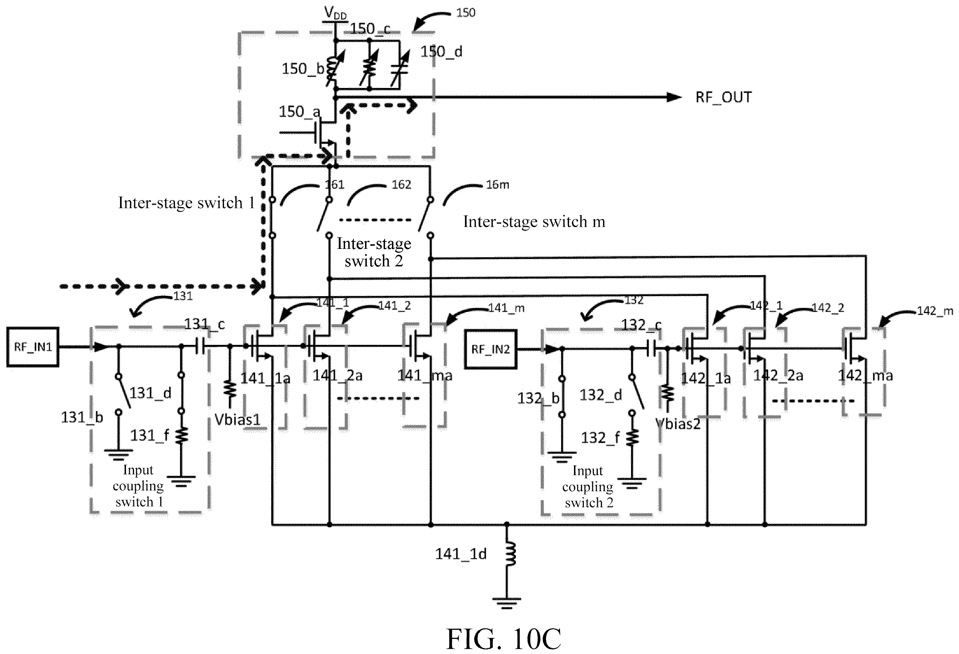

FIG. 10C shows another operating scenario of Embodiment 6. The low noise amplifier 100 operates in a low-gain mode. As shown in FIG. 10C, a radio frequency signal of a particular frequency band enters the first amplification path from the radio frequency signal input end RF_IN1, and the amplification path is enabled. In this case, the input coupling switch 131 is turned on. Specifically, in the input coupling switch 131, the switch 131_b is turned off, and the switch 131_d is turned on. Other operating states are the same as the descriptions in FIG. 4B. Details are not described herein again. In such low-gain mode, a part of the radio frequency input signal leaks to ground via a resistor 131_f. Therefore, compared with the scenario shown in FIG. 10B, the gain further decreases. The presence of the switch 131_d and the resistor 13 1_f provides an additional degree of freedom in implementation and selection of the gain. This allows for better trade-off between a noise factor, linearity, and a gain.

### Embodiment 7:

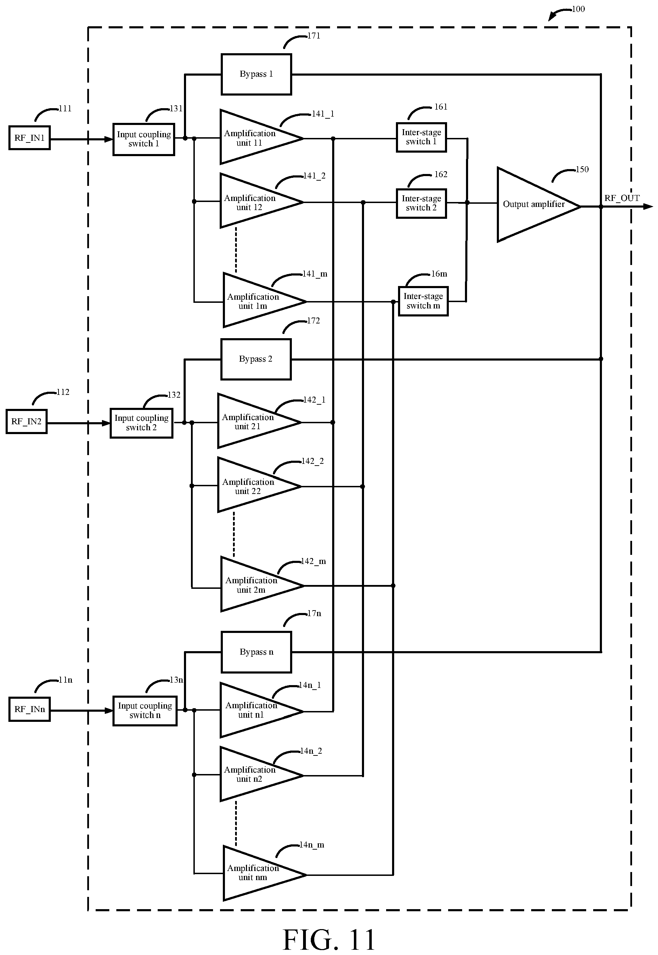

As shown in FIG. 11, a low noise amplifier 100 provided in Embodiment 7 includes a plurality of radio frequency signal input ends RF_IN1, RF_IN2, ..., and RF_INn. The first radio frequency signal input end RF_IN1 is connected to one end of a first input coupling switch 131, and the other end of the first input coupling switch 131 is connected to an input end of a first input amplifier. The first input amplifier includes m amplification units, which are amplification units 141_1, 141_2, ..., and 141_m. Input ends of the m amplification units are connected together to form the input end of the first input amplifier. Further, the first amplification unit 141_1 in the first input amplifier is connected to a first end of a first inter-stage switch 161. The second amplification unit 141_2 is connected to a first end of a second inter-stage switch 162. By analogy, the m^{th} amplification unit 141_m is connected to a first end of an m^{th} inter-stage switch 16m. A bypass circuit 171 is connected between an output end of the input coupling switch 131 and an output end RF_OUT of the low noise amplifier 100. By analogy, the n^{th} radio frequency signal input end RF_INn is connected to one end of an n^{th} input coupling switch 13n, and the other end of the n^{th} input coupling switch 13n is connected to an input end of an n^{th} input amplifier. The n^{th} input amplifier includes m amplification units, which are amplification units 14n_1, 14n_2, ..., and 14n_m. Input ends of the m amplification units are connected together to form the input end of the n^{th} amplifier. Further, the first amplification unit 14n_1 in the n^{th} input amplifier is connected to the first end of the first inter-stage switch 161. The second amplification unit 14n_2 in the n^{th} input amplifier is connected to the first end of the second inter-stage switch 162. By analogy, the m^{th} amplification unit 14n_m in the n^{th} input amplifier is connected to the first end of the m^{th} inter-stage switch 16m. A bypass circuit 17n is connected between an output end of the input coupling switch 13n and the output end RF_OUT of the low noise amplifier 100.

Second ends of the foregoing m inter-stage switches are connected together to form a common end. The common end is further connected to an input end of an output amplifier 150. The output amplifier 150 includes a driving circuit and the load circuit shown in FIG. 2B. A function of a bypass circuit is to allow a radio frequency input signal to bypass an active input amplifier, and to be directly coupled to a radio frequency signal output end via a passive amplification unit. When only the bypass circuit is enabled, the low noise amplifier 100 may provide a low gain with a negative value, that is, attenuation. Other parts of circuits in FIG. 11 are the same as the corresponding parts in FIG. 2A. Details are not described herein again.

### Embodiment 8:

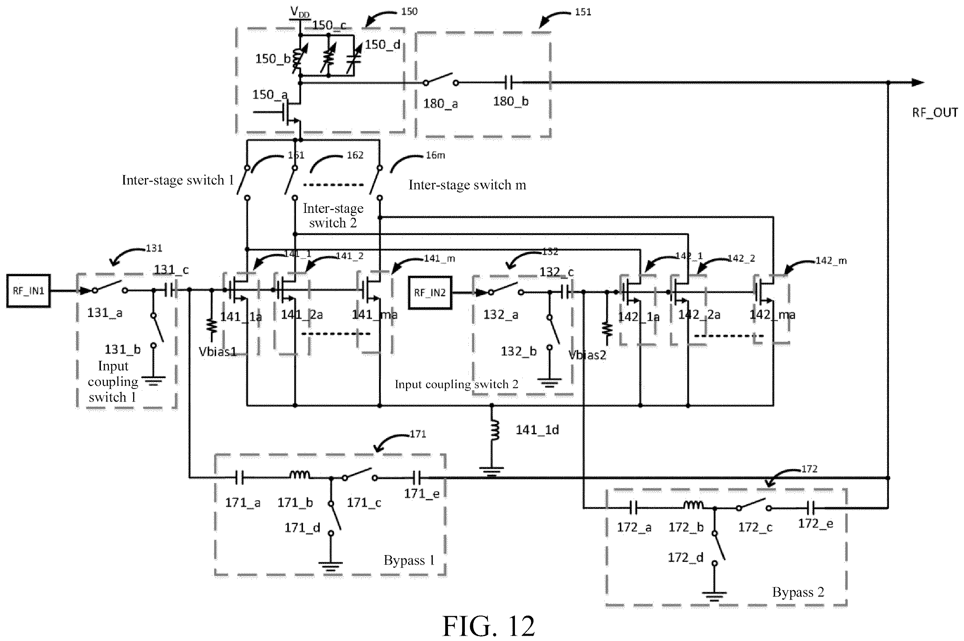

As shown in FIG. 12, in Embodiment 8, two bypass circuits 171 and 172 are added based on Embodiment 2. The two bypass circuits (within dashed lines) have exactly identical structures and each include a capacitor, an inductor, and a switch. The bypass circuit 171 is used as an example. An input end of the bypass circuit is connected to one end of a capacitor 171_a. The other end of the capacitor 171_a is connected to one end of an inductor 171_b. The other end of the inductor 171_b is connected to one end of a serial switch 171_c. The other end of the switch is connected to one end of a capacitor 171_e. The other end of the capacitor 171_e is connected to an output end of the bypass circuit 171. A junction of the inductor 171_b and the switch 171_c is connected to one end of a shunt switch 171_d, and the other end of the shunt switch 171_d is grounded.

One end of the bypass circuit 171 is connected to an output end of a first input coupling switch 131, that is, an input end of the first input amplifier. The other end of the bypass circuit 171 is connected to a radio frequency signal output end RF_OUT. One end of the bypass circuit 172 is connected to an output end of a second input coupling switch 132, that is, an input end of the second input amplifier. The other end of the bypass circuit 172 is connected to a radio frequency signal output end RF_OUT.

An output matching circuit 151 is connected between an output end of an output amplifier 150 and the radio frequency signal output end RF_OUT. The output matching circuit includes at least one switch 180_a and at least one capacitor 180_b connected to the switch in series. The other end of the capacitor 180_b is connected to the radio frequency signal output end. The remaining circuits in Embodiment 8 are the same as the circuits in Embodiment 2. Details are not described herein again.

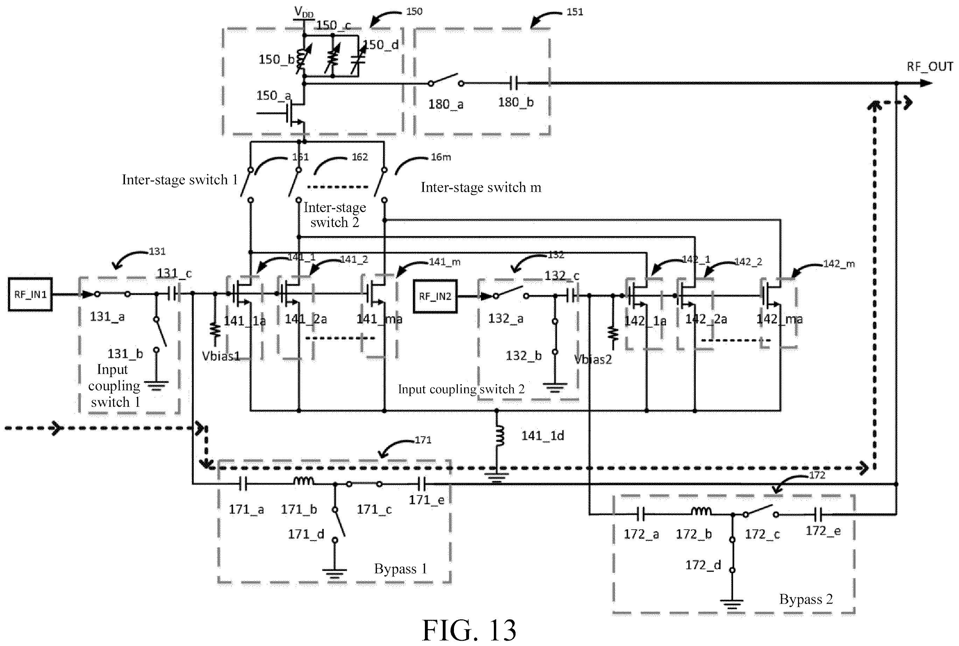

FIG. 13 shows an operating scenario of Embodiment 8. The low noise amplifier 100 operates in a low-gain mode. As shown in FIG. 13, a radio frequency signal of a particular frequency band enters a first amplification path from a radio frequency signal input end RF_IN1. All the input amplifiers are disabled, and bias voltages Vbias1 and Vbias2 are configured as ground potential or configured to be far less than a transistor threshold voltage. The output amplifier 150 is disabled, and a bias voltage of a driving transistor 150_a is configured as the ground potential or configured to be far less than the transistor threshold voltage. A serial switch 180_a in the output matching circuit 151 is turned off. All inter-stage switches (161, 162, ..., and 16m) are turned off. In addition, the input coupling switch 131 is turned on. Specifically, in the input coupling switch 131, a switch 131_a is turned on, and a switch 131_b is turned off. The input coupling switch 132 is turned off. Specifically, in the input coupling switch 132, a switch 132_a is turned off, and a switch 132_b is turned on and grounded. The bypass circuit 171 is turned on. Specifically, in the bypass circuit 171, the switch 171_c is turned on, and the switch 171_d is turned off. The bypass circuit 172 is turned off. Specifically, in the bypass circuit 172, a switch 172_c is turned off, and a switch 172_d is turned on and grounded.

The radio frequency signal passes through the input coupling switch 131 from the radio frequency signal input end RF_IN1 in a direction indicated by dashed lines in FIG. 13, enters the bypass circuit 171, and is finally coupled to the radio frequency signal output end RF_OUT. Because components in the bypass circuit are all passive components, the circuit solution in Embodiment 8 implements a low gain, that is, attenuation, of the low noise amplifier 100. The bypass circuit has a direct current blocking function and provides an output matching circuit. This further optimizes circuit performance in the operating scenario.

It should be noted that embodiments in the present invention are merely examples, and there may be other implementations for functional circuits in the embodiments that do not beyond the substantial content of the present invention. For example, the input coupling switch 131 in FIG. 13 may be replaced with the input coupling switch in FIG. 7B or FIG. 9B. In addition, as shown in FIG. 13, in the bypass circuit 171, the shunt switch 171_d may be positioned after the serial switch 171_c but not before the current serial switch 171_c in FIG. 13. Alternatively, the shunt switch may be removed. The bypass circuit may be independently provided on partially or all of the amplification paths. For example, the bypass circuit 171 in FIG. 13 is retained, and the bypass circuit 172 is removed. Whether to remove the bypass circuit specifically depends on design indicators such as an area and performance of the circuit. In FIG. 13, the connection of a source of each transistor in each amplification unit with a degeneration inductor may be replaced with any connection method in the foregoing embodiments.

In addition, the embodiments or variants in the present invention are all described in a related manner. For identical or similar parts in the embodiments or variants, reference may be made to one another. Although descriptions of the embodiments or variants focus on differences from other embodiments, all of the embodiments or variants are implemented based on the operation principle of a low noise amplifier. Details are not described herein.

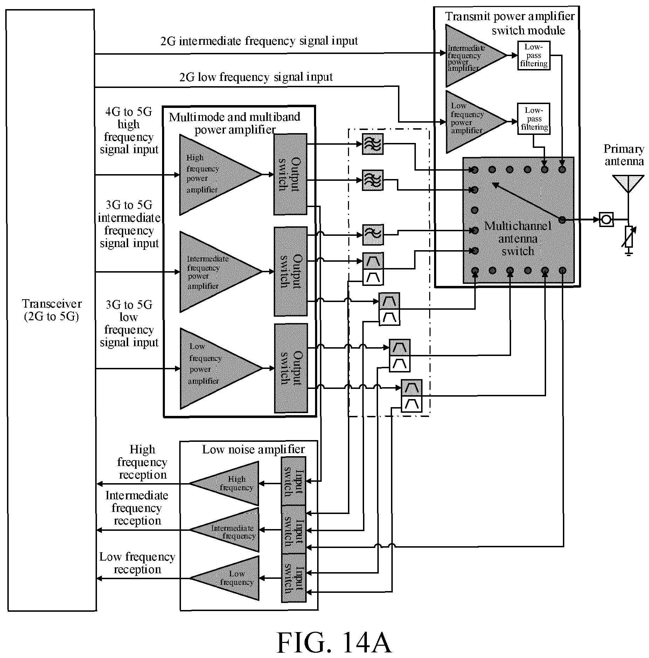

An embodiment of the present invention further provides a radio frequency front-end module. As shown in FIG. 14A, the radio frequency front-end module is connected between a transceiver (2G to 5G) and a primary antenna, including a multimode and multiband power amplifier, a transmit power amplifier switch module, and the foregoing low noise amplifier. In a radio frequency signal transmit path, a high frequency power amplifier, an intermediate frequency power amplifier, and a low frequency power amplifier in the multimode and multiband power amplifier respectively receive a high frequency signal, an intermediate frequency signal, and a low frequency signal from the transceiver, and amplify these signals and then input amplified signals to corresponding filter groups via respective output switches. A corresponding filter is provided on each signal channel, and the filters jointly form a filter group. Filtered signals are further transmitted to a multichannel antenna switch in the transmit power amplifier switch module, and are finally transmitted via the primary antenna. In addition, in a radio frequency signal receive path, a received radio frequency signal is transmitted to a corresponding filter group by the primary antenna via the multichannel antenna switch in the transmit power amplifier switch module, and is then transferred to the low noise amplifier. The input coupling switches in the low noise amplifier respectively receive a high frequency signal, an intermediate frequency signal, and a low frequency signal, and input amplified signals to the transceiver. The low noise amplifier includes variable gain amplifiers with a plurality of inputs and a plurality of outputs corresponding to signals of a high frequency band, an intermediate frequency band, and a low frequency band. Under the action of a control signal, the low noise amplifier enters an appropriate amplification mode to provide a particular amplification gain for a received signal.

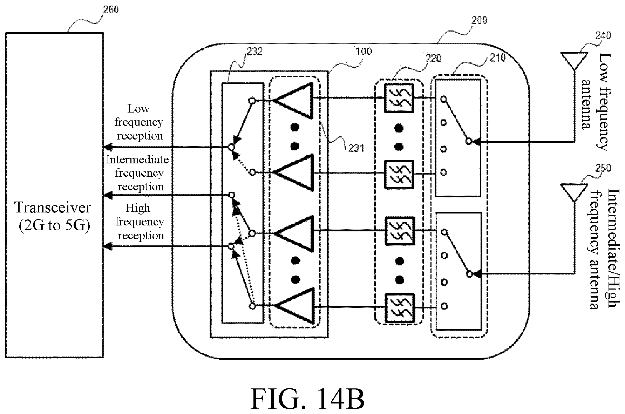

As shown in FIG. 14B, in another embodiment of the radio frequency front-end module, a radio frequency front-end module 200 is connected between a transceiver 260 and an antenna 240 as well as an antenna 250. The antenna 240 receives a low frequency signal, and the antenna 250 receives intermediate and high frequency signals. In some simpler designs, the two antennas may be replaced by one antenna, and the remaining parts keep unchanged. After received by the antenna 240 or the antenna 250, a radio frequency signal is transmitted to an antenna switch module 210, and is switched to a specified path via the antenna switch module 210. A corresponding filter is provided on each signal receiving channel, and the filters form a filter group. The filter may be a surface acoustic wave filter. Each filtered received signal is inputted to the low noise amplifier 100, and is amplified by the amplifier in a variable gain amplifier group 231 matched with the low noise amplifier. A quantity of the amplifiers is at least the same as the filtered inputted signals. Each inputted signal is connected to an input end of a corresponding amplifier in the variable gain amplifier group 231. A gain of each amplifier is determined by a control unit in the low noise amplifier 100. The low noise amplifier 100 may further include output change-over switches 232. Each of the switches has one end connected to a radio frequency signal output end of the amplifier, and the other end connected to an output end of the module. The output change-over switches 232 may enable a plurality of amplifiers in the variable gain amplifier group 231 to share a same receiving port on the transceiver 260 in a time-division manner, thereby improving flexibility of an output interface and facilitating implementation of carrier aggregation.

Further, an embodiment of the present invention further provides a radio frequency signal transmission control method for the foregoing radio frequency front-end module, including at least the following steps:
controlling an input coupling switch to be turned on, to allow a radio frequency signal to be inputted to an input end of an input amplifier;
controlling a plurality of inter-stage switches to be turned on, to control one or more amplification units in the input amplifier to separately amplify the inputted radio frequency signal, and input the radio frequency signal amplified by the amplification unit to an input end of a load circuit;
controlling the on/off of a bias circuit of each amplification unit;
controlling the on/off of a bypass circuit;
controlling a variable inductor, a variable capacitor, and a variable resistor in the load circuit, to provide load impedance having a particular frequency response; and
controlling a turn-on path of an output change-over switch, to allow the amplified radio frequency signal to be outputted to a specified output end.

Further, a drain of a transistor of each amplification unit is coupled to a corresponding inter-stage switch, and when the inter-stage switch corresponding to the transistor is turned on, the transistor is turned on, and the inputted radio frequency signal is amplified by the transistor.

The radio frequency signal is inputted to the input end of the load circuit via the inter-stage switch, and an output voltage is generated at an output end of the load circuit.

Further, different amplification gains of the radio frequency signal are implemented by controlling different combinations of the inter-stage switches that are either turned on or off, an impedance feature presented by the load circuit, and the on/off of the bypass circuit.

The foregoing examples describe control methods when the radio frequency signal is amplified. A person skilled in the art may understand that the control unit may perform multiple combinations of control modes. For example, when the amplification units do not need to perform amplification and the load circuit does not need to operate, the bypass circuit may be controlled to be enabled, to allow the received radio frequency signal to be directly outputted to the output end. For example, the control unit may control different combinations of amplification units to operate by controlling how the plurality of inter-stage switches are combined and turned on, to implement different gain modes. It should be noted that the control unit herein may be implemented by a processor in a mobile terminal, or may be implemented by a micro controller unit (MCU) or a field-programmable gate array (FPGA)

The low noise amplifier provided in the present invention can be used in a mobile terminal as an important part of a communication assembly such as a radio frequency front-end module. The mobile terminal herein refers to a wireless communication device that support a plurality of communications standards such as GSM, EDGE, TD_SCDMA, TDD_LTE, and FDD_LTE and can be used in a mobile environment, including a mobile phone, a notebook computer, a tablet computer, an Internet of vehicles terminal, or the like. In addition, the technical solutions provided in the present invention are also applicable to another scenario in which the radio frequency front-end module is used, for example, a communication base station or an intelligent network vehicle.

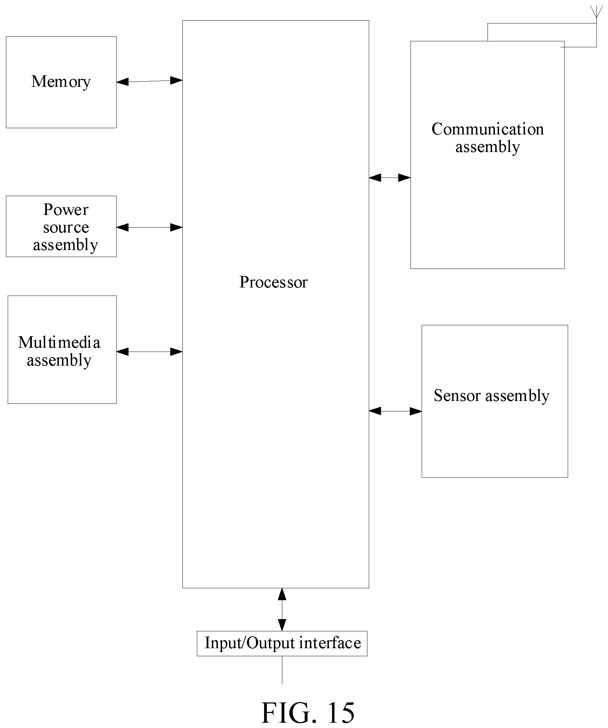

As shown in FIG. 15, the mobile terminal includes at least a processor and a memory, and may further include a communication assembly, a sensor assembly, a power source assembly, a multimedia assembly, and an input/output interface according to actual needs. The memory, the communication assembly, the sensor assembly, the power source assembly, the multimedia assembly, and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic disk memory, a flash memory, or the like. The processor may be a central processing unit (CPU), a graphics processing unit (GPU), a field-programmable gate array (FPGA), an application-specific integrated circuit (ASIC), a digital signal processor (DSP) chip, or the like. The communication assembly, the sensor assembly, the power source assembly, the multimedia assembly, and the like can all be implemented by universal components. Details are not described herein.

It can be learned from the detailed descriptions of the technical solutions of the present invention in the foregoing embodiments that in the low noise amplifier provided in the present invention, a plurality of input amplifiers and a plurality of input switching transistors are used, so that high isolation between input ports is achieved, while reducing the area occupied by circuits. Different gains of the low noise amplifier are implemented by breaking down each input amplifier into a plurality of amplification units and inter-stage switches connected to the amplification units and controlling different combinations of the inter-stage switches to be turned on. Sharing at least one output amplifier can ensure a high gain and high isolation of the low noise amplifier and minimize the area of the circuit. Each corresponding output amplifier includes a configurable load circuit. Impedance of the load circuit can be adjusted based on different gain requirements and frequency band requirements of an inputted signal, to achieve performance optimization.

The low noise amplifier, the corresponding radio frequency front-end module, the method, and the mobile terminal provided in the present invention are described above in detail. For a person of ordinary skill in the art, any obvious modifications made to the present invention without departing from the substantial content of the present invention fall within the protection scope of the patent right of the present invention.

## Claims

1. A low noise amplifier, comprising: a plurality of input amplifiers and a plurality of signal input ends, wherein a quantity of the input amplifiers is greater than or equal to a quantity of the signal input ends;
a plurality of input coupling switches, where two ends of each input coupling switch are respectively connected to one signal input end and an input end of one input amplifier; and
each input amplifier comprises at least one amplification unit, and control ends of the amplification units are connected together to form an input end of the input amplifier; and
a plurality of inter-stage switches, wherein one end of each inter-stage switch is connected to an output end of a corresponding amplification unit in each input amplifier, the other ends of the inter-stage switches are connected together to form a common end, and
the common end is connected to one output amplifier.

2. The low noise amplifier according to claim 1, wherein the output amplifier comprises:
a configurable load circuit, wherein an output end of the load circuit is connected to an output end of the low noise amplifier via an output matching circuit, and the other end of the load circuit is connected to a power source; and
a driving circuit, wherein one end of the driving circuit is connected to the common end of the inter-stage switches, and the other end of the driving circuit is connected to the output end of the load circuit.

3. The low noise amplifier according to claim 2, wherein
the load circuit comprises a variable inductor, a variable resistor, and a variable capacitor connected in parallel; and a resonant frequency of the load circuit is adjusted and different output impedance is provided by changing capacitance of the variable capacitor and resistance of the variable resistor.

4. The low noise amplifier according to claim 2, wherein
the driving circuit comprises at least one transistor, the transistor has a drain connected to the output end of the load circuit, a source connected to the common end of the plurality of inter-stage switches, and a gate connected to a control voltage.

5. The low noise amplifier according to claim 1, wherein
an output end of each amplification unit is connected to a corresponding inter-stage switch, and an amplification gain varies at least partially depending on a combination of the inter-stage switches that are either turned on or off.

6. The low noise amplifier according to claim 1, wherein
the input amplifiers each comprise a same quantity of amplification units; control ends of the amplification units in a same input amplifier are connected together and share one single bias voltage, and each input amplifier is individually connected to a bias voltage that is independently set; and output electrodes of corresponding amplification units in each amplifier are connected together, and are connected to an input end of a same inter-stage switch.

7. The low noise amplifier according to claim 5 or 6, wherein
each amplification unit comprises at least one transistor, and a radio frequency signal is transmitted to a gate of the transistor; when both the transistor and the inter-stage switch connected to the transistor are turned on, the radio frequency signal is amplified by the transistor and is coupled to a corresponding inter-stage switch by a drain of the transistor; and a source of the transistor is grounded via a degeneration inductor.

8. The low noise amplifier according to claim 1, wherein
each input coupling switch comprises at least one serial capacitor and a parallel shunt switch on a signal path; when the input coupling switch is turned on, the parallel shunt switch is turned off, and a radio frequency signal is transmitted to the input end of the input amplifier and amplified; and when the input coupling switch is turned off, the parallel shunt switch is turned on and grounded, and the signal path does not amplify an inputted signal.

9. The low noise amplifier according to claim 8, wherein
the input coupling switch further comprises a serial switch or a parallel switch resistance branch, or a combination thereof on the signal path;
when the input coupling switch is turned on, a radio frequency signal is transmitted to the input end of the input amplifier and amplified, and a switch in the parallel switch resistance branch is on in at least one gain mode; and when the input coupling switch is turned off, the serial switch is turned off, the parallel shunt switch is turned on and grounded, and the signal path does not amplify a signal.

10. The low noise amplifier according to claim 1, further comprising at least one bypass circuit, wherein
one end of the bypass circuit is connected to an output end of the low noise amplifier, and the other end of the bypass circuit is connected to an input end of one input amplifier; at least one serial control switch is connected between an output end of a load circuit and the output end of the low noise amplifier; and when the bypass circuit is enabled, the input amplifier and the output amplifier are disabled, the serial control switch is turned off, and a radio frequency input signal is transmitted via the bypass circuit to the output end of the low noise amplifier.

11. A radio frequency front-end module, comprising the low noise amplifier according to any one of claims 1 to 10.

12. A radio frequency signal transmission control method for the radio frequency front-end module according to claim 11, comprising the following steps:
controlling an input coupling switch to be turned on, to allow a radio frequency signal to be inputted to an input end of an input amplifier;
controlling a plurality of inter-stage switches to be turned on, to control one or more amplification units in the input amplifier to separately amplify the inputted radio frequency signal, and input the radio frequency signal amplified by the amplification unit to an input end of a load circuit;
controlling the on/off of a bias circuit of each amplification unit;
controlling the on/off of a bypass circuit;
controlling a variable inductor, a variable capacitor, and a variable resistor in the load circuit, to provide load impedance having a particular frequency response; and
controlling a turn-on path of an output change-over switch.

13. The radio frequency signal transmission control method according to claim 12, wherein
a drain of a transistor of each amplification unit is coupled to a corresponding inter-stage switch, and when the inter-stage switch corresponding to the transistor is turned on, the transistor is turned on, and the inputted radio frequency signal is amplified by the transistor; and
the radio frequency signal is inputted to the input end of the load circuit via the inter-stage switch, and an output voltage is generated at an output end of the load circuit.

14. The radio frequency signal transmission control method according to claim 12, wherein
different amplification gains of the radio frequency signal are implemented by controlling different combinations of the inter-stage switches that are either turned on or off, an impedance feature presented by the load circuit, and the on/off of the bypass circuit.

15. A mobile terminal, wherein a radio frequency front-end module in the mobile terminal comprises the low noise amplifier according to any one of claims 1 to 10.
